# EUROPEAN PATENT APPLICATION

(11) **EP 4 750 304 A1**
(43) Date of publication of application: **27.05.2026**
(21) Application number: 25211683.5
(22) Date of filing: 28.10.2025
(51) Int. Cl.: H10P 14/24, H10P 14/20, H10P 90/00, H10W 10/10

(54) **METHOD OF FORMING A SILICON ON INSULATOR SUBSTRATE**

(30) Priority: 26.11.2024 KR 20240170621
(71) Applicant: SK hynix Inc., Bubal-eub Icheon-si Gyeonggi-do 17336 (KR)
(72) Inventor: KIM, Il Do, 17336 Icheon-si, Gyeonggi-do (KR); SONG, Jae Sun, 17336 Icheon-si, Gyeonggi-do (KR); KIM, Seung Bum, 17336 Icheon-si, Gyeonggi-do (KR)
(74) Representative: Isarpatent

(57) **Abstract**

A method of forming an SOI substrate including a hydrogen thermal treatment performed on a pretreated sacrificial wafer, under high temperature. A stopper layer and a semiconductor layer may be sequentially formed on a first surface of the sacrificial wafer on which the hydrogen (H₂) thermal treatment was performed. The stopper layer and the semiconductor layer may be formed by an epitaxial growth process using a mixed precursor including a monosilane (MS) source and a dichlorosilane (DCS) source.

## Description

### BACKGROUND

### 1. Technical Field

Various embodiments of the present disclosure relate generally to a method of forming a silicon on insulator (SOI) substrate, and more specifically, to a method of forming a SOI substrate capable of reducing a leakage current in a channel.

### 2. Related Art

A unit memory cell of a memory device may include at least one cell transistor and at least one storage element. For example, the unit memory cell of a dynamic random access memory (DRAM) may use a capacitor as the storage element.

As the density requirement of memory devices is increased, various technical challenges arise, such as, for example, achieving sufficient capacitance for a DRAM because the area of the unit memory cell decreases. As a result, a vertical memory cell has been proposed.

A silicon-on-insulator (SOI) substrate may be used for a transistor structure in a vertical memory cell. The SOI substrate may include a layer of semiconductor material (e.g., silicon) separated from a wafer by an insulation layer, and the semiconductor material layer of the SOI substrate may act as a channel when a cell transistor is formed.

However, the channel, for example, a semiconductor layer in the SOI substrate applied to the vertical memory cell may be in a floating body state and therefore may suffer from high leakage current characteristics. Therefore, further improvements are needed for this technology to gain wider practical application.

### SUMMARY

Embodiments of the present disclosure provide a method of forming a SOI substrate with a semiconductor layer having improved leakage current characteristics.

According to embodiments of the present disclosure, there is provided a method of forming an SOI substrate. The method includes performing a hydrogen (H₂) thermal treatment on a pretreated sacrificial wafer, under high temperature. A stopper layer and a semiconductor layer may be sequentially formed on a first surface of the sacrificial wafer on which the hydrogen thermal treatment was performed. The stopper layer and the semiconductor layer may be formed by an epitaxial growth process using a mixed precursor including a monosilane (MS) source and a dichlorosilane (DCS) source.

According to embodiments of the present disclosure, there is provided a method of forming an SOI substrate. The method includes performing a hydrogen thermal treatment on a pretreated sacrificial wafer, under a high temperature; forming a stopper layer on the sacrificial wafer following the hydrogen thermal treatment; forming a semiconductor layer formed on the stopper layer, forming a blocking oxide layer over the semiconductor layer; and forming a first bonding insulating layer over the blocking oxide layer, to form a first structure. The stopper layer and the semiconductor layer are formed by an epitaxial growth method.

According to various embodiments, the pretreatment process may include a cleaning process and a drying process of the sacrificial wafer, before forming the stopper layer and the semiconductor layer on the sacrificial wafer. Thus, crystal defects caused by oxide-like impurities in the stopper layer and the semiconductor layer formed during the subsequent epitaxial process may be prevented.

Further, in the hydrogen (H₂) thermal treatment of forming the stopper layer and the semiconductor layer on the sacrificial wafer, residues (for example, residual oxygen) on the sacrificial wafer may be completely removed, and a Si migration may be generated on the sacrificial wafer from which the resides may be completely removed, thereby improving roughness of the sacrificial wafer.

Furthermore, by using the precursor of monosilane (MS) source and dichlorosilane (DCS) source to form the stopper layer (for example, SiGe layer) and the semiconductor layer (for example, Si layer), SiGe/Si grain growths may be prevented by chlorine (Cl) ions including an etching property which is generated during a decomposition of the DCS source. In addition, a leakage current characteristic of the memory device may be improved as the crystal defects may be reduced through improved roughness of a boundary between the SiGe layer and the Si layer, and reduced Si dangling bonds.

### BRIEF DESCRIPTION OF THE DRAWINGS

The above and another aspects, features and advantages of the subject matter of the present disclosure will be more easily understood from the following detailed description taken in conjunction with the accompanying drawings, in which:

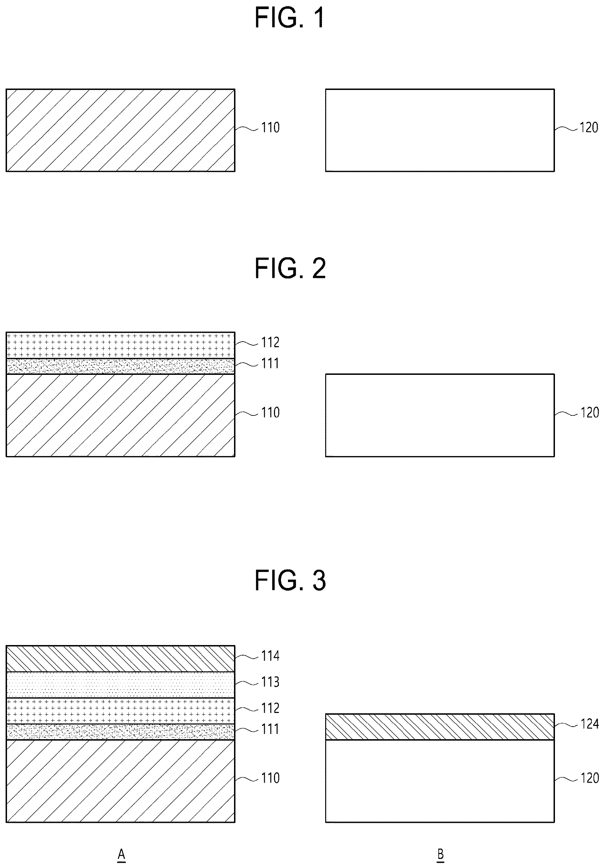

FIGS. 1 to 7 are cross-sectional views illustrating a method of forming an SOI substrate in accordance with embodiments of the present disclosure.

### DETAILED DESCRIPTION

The advantages and features of the embodiments of the present disclosure, and methods of achieving them, will become apparent upon reference to the embodiments described in detail with reference to the accompanying drawings. This disclosure, however, is not limited to the embodiments disclosed herein, and the embodiments may be embodied in many different forms. The described embodiments are provided to make this disclosure complete and to give those having ordinary skill in the art a complete understanding of the technical concepts and scope of the embodiments as defined by the claims. The dimensions and relative sizes of the layers and regions in the drawings may be exaggerated for clarity of description. Throughout the specification, like reference numerals may refer to like components.

FIGS. 1 to 7 are cross-sectional views illustrating a method of forming an SOI substrate in accordance with embodiments of the present disclosure.

Referring to FIG. 1, a sacrificial wafer 110 and a reference wafer 120 may be provided. For example, the sacrificial wafer 110 and the reference wafer 120 may include at least one material selected from silicon (Si), germanium (Ge), silicon carbide (SiC), IV-IV group, III-V group, or II-VI group semiconductor compounds, and piezoelectric materials (e.g., LiNbO3, LiTaO3, etc.).

In various embodiments, the sacrificial wafer 110 may be subjected to a pretreatment process. The pretreatment process of the sacrificial wafer 110 may include a cleaning process to remove a native oxide and an organic material from the sacrificial wafer 110. The pretreatment process of the sacrificial wafer 110 may further include a drying process to prevent an oxide regrowth of the sacrificial wafer 110. For example, the sacrificial wafer 110 may include a polished surface. The pretreatment may be performed on the polished surface of the sacrificial wafer 110.

In some embodiments, the cleaning process of the sacrificial wafer 110 may be performed using a hydrofluoric acid (HF) diluted in water. This process is referred to as a diluted HF (DHF) cleaning process. For example, the DHF cleaning process of the sacrificial wafer 110 may be performed using hydrofluoric acid (HF) diluted to a ratio of 100:1 to 200:1 in deionized water (DI water, DIW). Further, the drying process of the sacrificial wafer 110 may be performed using a nitrogen (N₂) gas.

As described above, by the pretreatment process of the sacrificial wafer 110, crystal defects due to oxide-like impurities in a stopper layer 111 (see FIG. 2) and a semiconductor layer 112 (see FIG. 2) to be formed through a subsequent epitaxial process may be prevented.

Referring now to FIG. 2, a stopper layer 111 and a semiconductor layer 112 may be formed on a first surface (for example, the top surface) of the sacrificial wafer 110. For example, the first surface of the sacrificial wafer 110 may be a surface on which the pretreatment has been performed. Further, the sacrificial wafer 110 may include a second surface opposite to the first surface. In some embodiments, the stopper layer 111 and the semiconductor layer 112 may be formed by an epitaxial growth through an in-situ technique.

In some embodiments, the pretreated sacrificial wafer 110 may be performed by a hydrogen (H₂) thermal treatment under a high temperature, before the stopper layer 111 is formed. For example, the hydrogen thermal treatment of the sacrificial wafer 110 may be performed at a high temperature from 900°C to 1,200°C. As such, as the H₂ thermal treatment under the high temperature, that is, 900°C to 1,200°C, of the sacrificial wafer 110 is performed, a silicon (Si) migration may be generated on a surface of the sacrificial wafer 110, thereby improving a roughness of the surface of the sacrificial wafer 110. Further, as the oxide-like impurities of the surface of the sacrificial wafer 110 are removed by the hydrogen thermal treatment (or H2 Bake), the crystal defects may be reduced, which in turn improves the leakage current characteristics of a memory device.

The stopper layer 111 prevents the semiconductor layer 112 from being lost when the sacrificial wafer 110 is removed in a subsequent process. The stopper layer 111 may be formed using a material having a different etch selectivity than the sacrificial wafer 110 and the semiconductor layer 112. Additionally, the stopper layer 111 may be formed using a material having fewer physical differences from the semiconductor layer 112. In various embodiments, the stopper layer 111 may be a single crystalline silicon germanium (SiGe) layer.

In some embodiments, the stopper layer 111 may be formed by an epitaxial growth process. The epitaxial growth process may be performed using a mixed precursor with a monosilane (MS: SiH₄) source and a dichlorosilane (DCS: SiH₂Cl₂) source as a source gas, and a reaction gas under 600°C to 800°C. For example, the reaction gas may include germanium tetrahydride (GeH₄). A partial pressure ratio of the monosilane (MS) source and the dichlorosilane (DCS) source of the source gas may be 3:1.

Since chlorine (Cl) ions generated during a decomposition of the DCS source of the source gas may include an etching property, a roughness of the stopper layer 111, that is, SiGe may be improved, and Si dangling bonds of the stopper layer 111 may be reduced. As a result, crystal defects due to the roughness of the stopper layer 111 and Si dangling bonds of the stopper layer 111 may be reduced, and a leakage current characteristic of the memory device may be improved.

For example, when the stopper layer 111, for example, the SiGe layer, is formed by the epitaxial growth process, an island growth may be generated due to a compressive stress caused by a lattice mismatch between the Si material of the sacrificial wafer 110 and the SiGe layer of the stopper layer 111. Roughness characteristics of the SiGe layer may be deteriorated due to the occurrence of the island growth. As a result, during the epitaxial growth process for forming the semiconductor layer 112, a sharpness characteristic between the Si layer, which is the semiconductor layer 112, and the SiGe layer, which is the stopper layer 111, may be deteriorated. In addition, the generation of the island growth may increase the Si dangling bonds, which may deteriorate electrical characteristics of the memory device.

In various embodiments, by using the mixed precursor of the MS and the DCS sources as a Si source gas, protruding portions of the Si adsorbed on the sacrificial wafer 110 may be removed by the Cl ions decomposed from the DCS source after a Si epitaxial reaction, in which silicon ions are adsorbed on the sacrificial wafer 110. As a result, the island growth may be reduced during the epitaxial growth process for forming the stopper layer 111 and the semiconductor layer 112. The roughness characteristics of the SiGe layer, which is the stopper layer 111, and the sharpness characteristic of a bonding interface between the stopper layer 111 and the semiconductor layer 112 may be improved, and the Si dangling bonds may be reduced. As the roughness and sharpness characteristic of a surface of the SiGe layer are improved, when the stopper layer 111 is removed in the subsequent process, a surface roughness characteristic of the semiconductor layer 112 may be improved, so that a Chemical Mechanical Polishing (CMP) process and a treatment process for the semiconductor layer 112 becomes unnecessary.

In various embodiments, the stopper layer 111 may have a germanium (Ge) concentration of 10% to 30%. A thickness of the stopper layer 111 may range from 300 Å to 1,000 Å, but is not limited thereto.

In some embodiments, after the stopper layer 111 is formed, a purge process may be performed using the hydrogen gas. During the purge process, residual gas within the chamber may be removed, and defects on the surface of the stopper layer 111, such as, the Si dangling bonds may be removed by a hydrogen (H₂) passivation.

Referring again to FIG. 2, the semiconductor layer 112 may be formed on the stopper layer 111. For example, the semiconductor layer 112 may be a single crystalline silicon (Si) layer.

In some embodiments, the semiconductor layer 112 may be also formed by the epitaxial growth process using a mixed precursor including a compound of the MS and the DCS under 600°C to 800°C. For example, a partial pressure ratio of the MS and the DCS may be 3:1.

As described above, the chlorine (Cl) ions generated during a decomposition of the DCS source of the source gas for forming the semiconductor layer 112 may include an etching property, a Si grain growth, a Si roughness, and crystal defects due to the Si grain growth and the Si roughness may be reduced and a leakage current characteristic of memory devices may be improved.

As described above, in various embodiments, when the semiconductor layer 112 is formed by the compound including the DCS source and the MS source, protruding portions of a surface of the semiconductor layer 112 may be removed by the Cl decomposed from the DCS source. As a result, an island growth of the semiconductor layer 112 and the Si dangling bonds may be reduced, thereby improving the roughness characteristics of the surface of the semiconductor layer 112.

Referring to FIG. 3, a blocking oxide layer 113 may be formed over the semiconductor layer 112, and a first bonding insulating layer 114 may be formed over the blocking oxide layer 113

In some embodiments, the blocking oxide layer 113 may include a silicon oxide (SiO₂) layer or a silicon oxynitride (SiON) layer, but is the embodiments are not particularly limited thereto.

Next, the reference wafer 120 may be provided. A second bonding insulating layer 124 may be formed over the reference wafer 120. In various embodiments, the first bonding insulating layer 114 and the second bonding insulating layer 124 may be formed simultaneously in the same chamber, or may be formed simultaneously in different chambers. However, the embodiments may not be particularly limited in this way.

In some embodiments, the first and second bonding insulating layers 114 and 124 may include a silicon carbonitride (SiCN) layer, but the embodiments are not particularly limited thereto.

When the first and second bonding insulating layers 114 and 124 have been formed, a first structure A including the sacrificial wafer 110 and the stopper layer 111, the semiconductor layer 112, the blocking oxide layer 113 and the first bonding insulating layer 114, and a second structure B including the reference wafer 120 and the second bonding insulating layer 124 may be prepared.

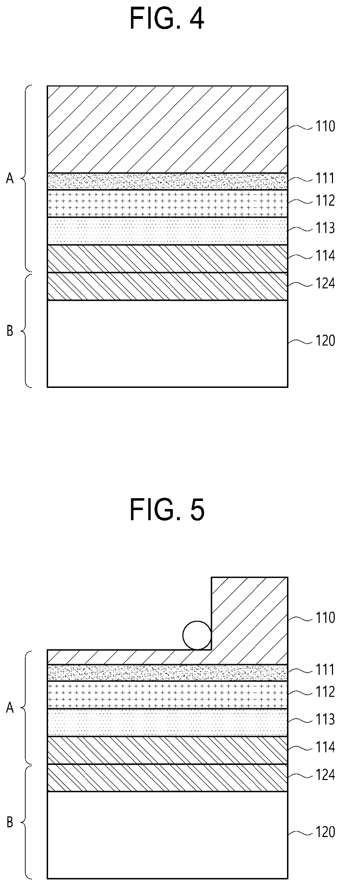

Referring to FIG. 4, the first structure A and the second structure B may be bonded such that the first bonding insulating layer 114 and the second bonding insulating layer 124 may be in contact. In various embodiments, the bonding of the first structure A and the second structure B may include a fusion bonding process performed on an interface between the first bonding insulating layer 114 and the second bonding insulating layer 124. The fusion bonding process may be performed, for example, at room temperature. Following the fusion bonding process, an annealing process may be performed to strengthen the bond of the interface between the first and second bonding insulating layers 114 and 124. For example, the annealing process may be performed using a nitrogen (N₂) gas at a temperature of 400°C to 650°C.

As shown in FIG. 4, after the first structure A is flipped, the flipped first structure A may be bonded to the second structure B, and the second surface of the sacrificial wafer 110 of the first structure A may be exposed.

Referring to FIG. 5, the exposed sacrificial wafer 110 may be trimmed to remove a selected portion of an edge of the sacrificial wafer 110 (Hereinafter, a trimming process).

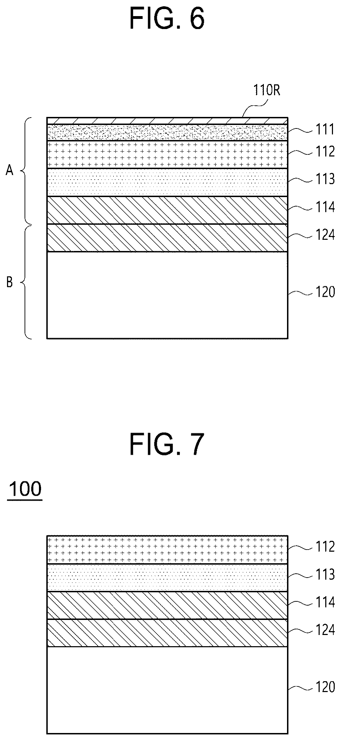

Referring to FIG. 6, the exposed sacrificial wafer 110 may be ground to a set thickness (or, height). In some embodiments, a remaining sacrificial wafer 110R may include a thickness of about 3 µm, but is the embodiments are not particularly limited thereto. When the sacrificial wafer 110 is ground, a cracking and chipping of the sacrificial wafer 110 may be reduced by the trimming process of the sacrificial wafer 110.

Referring to FIG. 7, the remaining sacrificial wafer 110R and the stopper layer 111 may be sequentially removed, thereby forming a SOI substrate 100.

In various embodiments, the remaining sacrificial wafer 110R may be removed using at least one of a wet cleaning process and a dry cleaning process. For example, the remaining sacrificial wafer 110R may be removed by successively performing a DHF (Diluted HF) pretreatment cleaning process and a wet alkaline (Diluted NH₄OH, TMAH: (CH₃)4N(OH) or KOH) post treatment cleaning process, followed by a drying process in an IPA (Isopropyl alcohol) Dryer.

Further, in some embodiments, the stopper layer 111 may be removed using at least one of the wet cleaning process and the dry cleaning process. For example, the stopper layer 111 may be removed using a wet alkaline (Diluted NH₄OH, TMAH: (CH₃)₄N(OH), KOH, etc.) cleaning process and the dry cleaning process using a fluorinated compound.

The SOI substrate 100 may include the second bonding insulating layer 124, the first bonding insulating layer 114, the blocking oxide layer 113 and the semiconductor layer 112 which are sequentially stacked on the reference wafer 120.

A surface of the semiconductor layer 112 may be exposed by removing the stopper layer 111. A cleaning process may be further performed to improve a roughness of the exposed surface of the semiconductor layer 112.

While the embodiments of the present disclosure have been described in detail with reference to certain embodiments, this disclosure is not limited to the above embodiments. The embodiments may be modified by those having ordinary skill in the art, and any modifications should be considered to fall within the scope of the present disclosure . Furthermore, the embodiments may be combined to form additional embodiments.

## Claims

1. A method of forming a silicon on insulator (SOI) substrate, the method comprising:
performing a hydrogen thermal treatment on a pretreated sacrificial wafer, under high temperature;
forming a stopper layer on the sacrificial wafer on which the hydrogen thermal treatment was performed; and
forming a semiconductor layer formed on the stopper layer,
wherein the stopper layer and the semiconductor layer are formed by an epitaxial growth using a mixed precursor comprising a monosilane (MS) source and dichlorosilane (DCS) source.

2. The method of claim 1, wherein the pretreated sacrificial wafer is formed by:
performing a cleaning process to remove native oxide and an organic material from a polished wafer; and
performing a drying process to prevent an oxide regrowth on the cleaned wafer.

3. The method of claim 2, wherein the cleaning process is performed using a cleaning solution including hydrofluoric acid (HF) diluted to a ratio of 100: 1 to 200: 1 in deionized water (DI water).

4. The method of claim 2, wherein the drying process is performed under a nitrogen (N₂) gas.

5. The method of claim 1, wherein a mole fraction of the monosilane source and dichlorosilane source of the mixed precursor is 3:1.

6. The method of claim 1, wherein the stopper layer comprises single crystalline silicon germanium (SiGe), and
wherein the stopper layer is formed by supplying germanium tetrahydride (GeH₄) as a reaction gas.

7. The method of claim 6, wherein the stopper layer is formed to have a germanium (Ge) concentration of 10% to 30%, and
wherein a thickness of the stopper layer includes 300 Å to 1,000 Å.

8. The method of claim 1, further comprising performing a purge process using a hydrogen gas before forming the semiconductor layer on the stopper layer.

9. The method of claim 1, further comprising:
forming a blocking oxide layer over the semiconductor layer; and
forming a first bonding insulating layer over the blocking oxide layer, to form a first structure.

10. The method of claim 9, further comprising:
forming a second bonding insulating layer on a reference wafer, to form a second structure.

11. The method of claim 10, further comprising:
bonding the first structure to the second structure to face the first bonding insulating layer of the first structure and the second bonding insulating layer of the second structure to form the SOI substrate.

12. The method of claim 11, wherein bonding the first structure to the second structure comprises:
performing a fusion bonding on an interface between the first bonding insulating layer and the second bonding insulating layer at room temperature; and
annealing the SOI substrate to strengthen a bond of the interface between the first bonding insulation layer and the second bonding insulation layer.

13. The method of claim 11, further comprising:
removing an edge portion of the sacrificial wafer of the first structure using a wafer trimming process; and
grinding a sacrificial wafer to form a remaining sacrificial wafer layer including a set thickness on the stopper layer.

14. The method of claim 13, further comprising:
removing the remaining sacrificial wafer layer using a wet cleaning process to expose the stopper layer; and
removing the exposed stopper layer using a dry cleaning process to expose the semiconductor layer.

15. The method of claim 14, further comprising:
cleaning a surface of the exposed semiconductor layer using a wet cleaning process.

16. A method of forming a silicon on insulator (SOI) substrate, the method comprising:
performing a hydrogen thermal treatment on a pretreated sacrificial wafer, under a high temperature;
forming a stopper layer on the sacrificial wafer following the hydrogen thermal treatment;
forming a semiconductor layer formed on the stopper layer,
forming a blocking oxide layer over the semiconductor layer; and
forming a first bonding insulating layer over the blocking oxide layer, to form a first structure.
wherein the stopper layer and the semiconductor layer are formed by an epitaxial growth method.
